# EUROPEAN PATENT APPLICATION

(11) **EP 1 292 173 A1**
(43) Date of publication of application: **12.03.2003**
(21) Application number: 02425537.4
(22) Date of filing: 30.08.2002
(51) Int. Cl.: H05B 33/04

(54) **Moisture sorbing device for displays comprising organic light emitting diodes and process for producing the same**

(30) Priority: 11.09.2001 IT MI20011895
(71) Applicant: SAES GETTERS S.p.A., Lainate (Milano) (IT)
(72) Inventor: Maeda, Chiharu, Saes Getters Japan Co, Ltd., Shinagawa-ku, Tokyo 141 (JP); della Porta, Anna, 20121 Milano (MI) (IT)
(74) Representative: Adorno, Silvano

(57) **Abstract**

A moisture sorbing device (10, 20) is described to be used in the displays of the organic light emitting diodes type. A process for producing moisture sorbing devices of the invention is also described.

## Description

The present invention is directed to a moisture sorbing device for displays comprising organic light emitting diodes and to a process for its manufacturing.

The organic light emitting diodes have been studied in the last years for producing flat displays, of very low thickness and weight. The most important applications which are foreseen in the short run are in the form of displays for cellular phones, stereo apparatuses, car instruments boards and the like, without excluding the production of displays of big size, capable of reproducing images in movement, to be employed for example as computer or television screens.

The light emitting organic diodes are better known in the specialized literature with the acronym OLED, which will be adopted in the following of the description. With the same term OLED not only the single diodes forming puntiform light sources, but also the displays consisting of a plurality of said diodes are indicated.

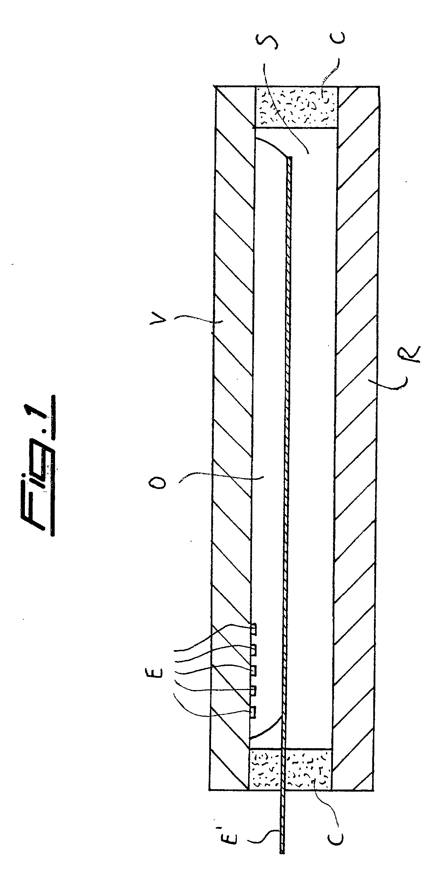

In summary, the structure of an OLED (schematically represented in the sectional view of figure 1) consists of a first transparent support V, essentially planar and generally made from glass or a plastic polymer; of a first row of electrodes E, transparent, rectilinear and parallel to each other being deposited on the first support; of a double layer, O, of different electroluminescent organic materials, the first of which is conductor of electrons and the second of electron holes, deposited on the first row of electrodes; of a second row of electrodes E', rectilinear and parallel to each other having an orientation perpendicular to those of the first row, in contact with the higher portion of the double layer of organic materials, whereby this is comprised between the two rows of electrodes; and of a second support not necessarily transparent, R, that can be made of glass, metal or plastics, essentially planar and parallel to the first support. The two supports are mutually fixed along their periphery, generally by gluing with an adhesive C, so that the active portion of the structure (electrodes, electroluminescent organic materials) is located in an enclosure S. The transparent support V is the portion on which the imagine is viewed, while the second support R has generally only the function of closing and backing up the device to provide the same with sufficient mechanical resistance.

The material forming the first row of transparent electrodes is usually ITO, a mixture of tin and indium oxides, but other mixtures of oxides can be also used, generally based on tin or zinc oxide, conducting polymers such as polyimides or extremely thin layers (hundreds of Angstrom) of metals having a high electric conductivity such as Al, Cu or Au.

The material of the second row of electrodes may be one of those indicated above for the first row or, in case of non transparent electrodes, a metal; the most commonly used materials are alloys Al-Li or Al-Mg or double composite layers formed of aluminum on which thin layers of alkaline of alkaline-earth metals or their compounds are deposited; examples of such composite double layers are Al-LiF or Al-Li₂O.

The electroluminescent organic materials can be in a polymeric form or as discrete molecules, but in any case of the poly-unsaturated species; the most commonly used compound is a complex of aluminum with quinoline.

For expounding the principles of functioning of the OLEDs and for more details on their structure reference is made to the literature in this field.

The main problem found with these devices is that they quickly loose their features of light emission in consequence of moisture sorption. The life of these devices is reduced from thousands or tens of thousand hours in absence of moisture, as experimentally tested in suitable chambers, to few hours when exposed to the atmosphere. Although the reasons of the functional degradation of OLEDs have not yet been completely clarified, it is likely that the phenomenon can be ascribed on one hand to reactions of adding the water molecule to the unsaturated bonds of the organic component, and on the other hand to the water reaction with the electrodes, in particular the metal cathodes. The main way for water to enter the OLEDs is the peripheral sealing of the two supports, which is generally carried out by gluing through water-permeable epoxy resins, used by almost all the manufactures. Moisture may also be released by the OLED inner components themselves.

US patents 5,804,917 and 5,882,761 and publications of international applications WO 98/59356 and WO 99/35681 disclose the use of moisture sorbing materials at the inside of devices. However all these documents show the use of the sorbing material in a generic way and do not explain how it is possible to integrate the step of introducing the sorbing material into the OLED during the device manufacturing process.

The research publication RD 430061 affords, with respect to the previously cited documents, a detailed description of the structure of a possible moisture sorbing device for OLEDs. Such a device is generically formed of a rectangle of two-layer aluminum-polyethylene sheet with a central groove in which a moisture sorbing material is housed in powdered form (e.g. CaO); along the edges of the aluminum sheet a sheet of water-permeable polymeric material is heat sealed, being capable of retaining the powdered particles of the sorber, for example a polyethylene woven-non-woven fabric. The assembly is a discrete article which can be placed in the enclosure (S) of the OLED, generally in contact with the second support (R) so that the water-permeable sheet is directed toward the active structure comprising of the electrodes (E, E') and the double organic layer (O).

However also the system described in RD 430061 suffers from some critical conditions of use. It is in fact necessary that the sorbing device is not brought to contact with the electrodes or the organic material layers to prevent these from being damaged by compression or friction, whereby the sorbing device has to be capable of being located in the enclosure S of the OLED while filling up only the lower portion thereof: at present the manufacturers of OLEDs are requiring sorbing devices of such a thickness that the maximum distance from the second support R is of about 0.4 mm everywhere. In the system according to RD 430061, the aluminum-polyethylene two-layer, which has to provide mechanical solidity to the assembly, should not be of thickness lower than about 0.065 mm, whereas the woven-non-woven fabric is generally thick 0.1 mm at least; in addition this device must be fixed to the second support R, usually by glues or bi-adhesive tape, whose thickness is of about 0.01-0.03 mm. Finally, the resulting sorption device may become deformed with respect to the planar ideal shape, either immediately after the manufacturing, or following the operations of introducing the same into the OLED, thus occupying a thickness greater than the theoretic one, with the above-mentioned risks of damaging the electrodes or the organic layers: this requires a further reduction of the "theoretical" thickness to ensure a safety margin that takes into account these possible dishomogeneties. The consequence is that the available thickness for the sorbing material is of 0.2 mm at the best, while it would be preferable to have the possibility of increasing the quantity of material charged in the device in order to ensure a better sorption capacity.

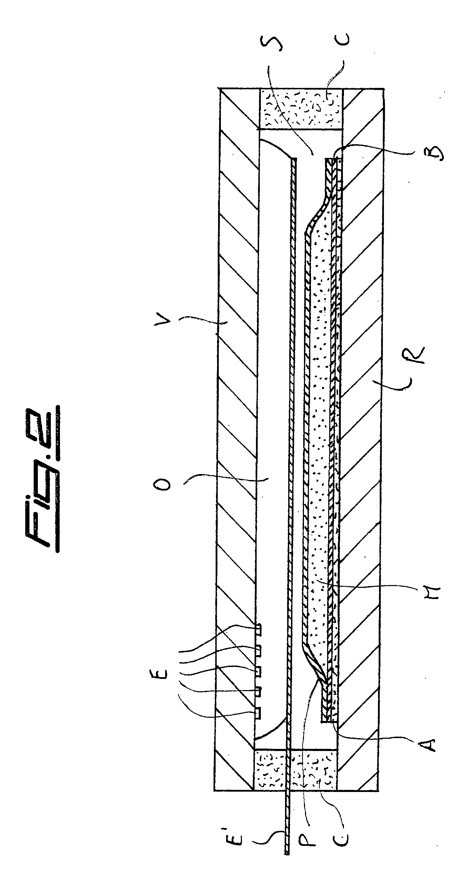

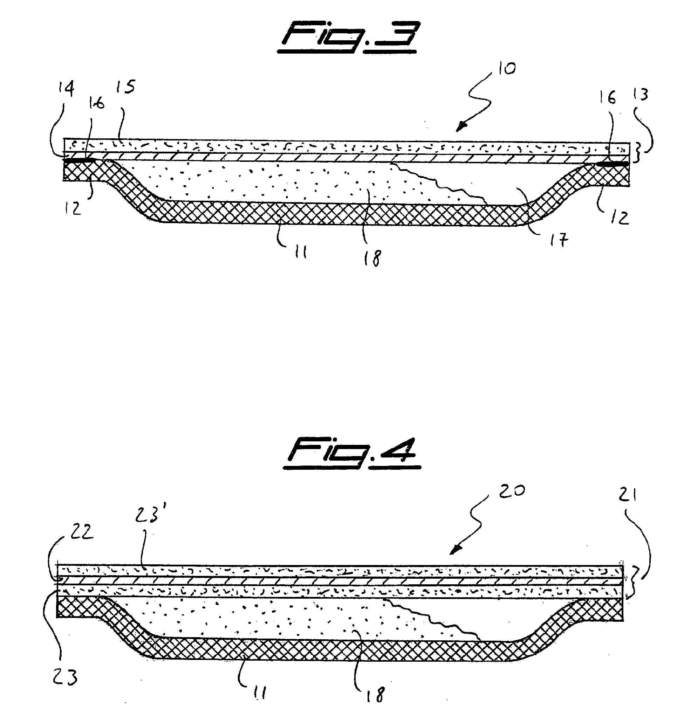

The Italian patent application MI2000A002098 in the name of the applicant entails an improvement with respect to the prior art devices. Such an application discloses a moisture sorbing system wherein the component parts are present in an "overturned" structure with respect to what is known, wherein the groove designed to house the sorbing material is obtained by punching of the water-permeable membrane, and the device is then completed with a sheet of a material impermeable to the fluids. An OLED containing such a sorbing device is schematically shown in cross-section in figure 2 (wherein reference letters corresponding to those of figure 1 have the same meaning): in the enclosure S there is inserted the device formed of the permeable membrane P and the impermeable sheet B, between which there is enclosed the sorbing material M; the device is in contact with the second support R by means of the sheet B. With such a configuration also the sealing edge between membrane P and sheet B is in contact with the support R, thus avoiding the risk that deformations thereof may bring it into contact with the active structure of OLED; furthermore, since in this case the portion affording mechanical resistance to the device is membrane P, it is possible to reduce the thickness of sheet B to values lower than the size of about 0.065 mm required in the prior configuration, thus increasing the room available for the material M. However, to be fixed to support R, also this system requires the use of an adhesive layer or a bi-adhesive tape (generally referred to in the drawing as element A), which add to the total thickness of the device to the detriment of the available volume for material M.

Object of the present invention is that of providing a moisture sorbing device for displays comprising light emitting organic diodes which does not show the drawbacks of the prior art, as well as providing a process for the manufacturing of such a device.

These objects are obtained according to the present invention which in a first aspect thereof is directed to a device formed of:
- a membrane being water-permeable but capable of retaining solid particles, having a perimetral edge upraised with respect to its central portion;
- a mono- or bi-adhesive sheet capable of retaining solid particles, fixed to the membrane along the whole said perimetral edge thus defining with the membrane an enclosed volume at said central portion of the membrane itself;
- a moisture sorbing material with water equilibrium pressure lower than 10⁻² mbar between -15°C and 130°C in said enclosed volume.

The inventors have found that the glues employed in producing mono- or bi-adhesive sheets or tapes have a good water permeation speed, so that, even if the glues come into contact with the moisture sorbing material, the water sorption speed of the latter still remain high enough to be compatible with the performances required within an OLED display; as a consequence it becomes possible to do without the impermeable sheet (e.g. of metal, plastics or two-layer composites plastics-metal) which was one of the elements composing the sorption devices of the prior art, by replacing the same with a mono- or bi-adhesive sheet. In particular, the device of the invention provides for an improvement of the sorption device which is the object of the cited patent application MI2000A002098, combining in only one element (the mono- or bi-adhesive sheet) the functions of adhering to the OLED second support and of sealing the device.

The device of the invention is formed of a membrane and a mono- or bi-adhesive sheet being fixed to each other along their periphery; the membrane has a cavity in its central zone where the sorbing material is located.

The membrane has the function of confining the sorbing material in a region of the enclosure S of an OLED display while allowing the moisture in said enclosure to come easily and rapidly into contact with the sorbing material. To this purpose, the membrane must preferably have a conductivity against water that is higher than 0.1 mg/(hour x cm²). The membrane must also show a sufficient mechanical solidity so that it can be formed by punching. Said membrane can be of the type with homogeneous size and distribution of holes; such a membrane can be formed of a wire net, a polymeric fabric or a metallic or polymeric sheet with micro-holes. Among these, for cost and weight reasons, the use of membranes in polymeric material is preferred. These membranes must have openings not larger than 20 µm to be capable to retain the powders of the sorbing material. In alternative it is possible to use membranes with non-uniform distribution and size of the pores, such as e.g. the sheets of aluminum having thickness of 4 or 5 µm manufactured by the Japanese company Toyo, which are provided with micro-holes having a random distribution or, preferably, membranes of woven-non-woven fabrics. Typical membranes in woven-non-woven fabrics are those made in polyethylene, for example of high density (known in the art as HDPE); membranes of this type are available in the trade with the name Tyvek® (registered trademark of the company du Pont de Nemours). Empirically it has been determined that a membrane of woven-non-woven fabric in HDPE with a thickness of at least 0.12 mm is provided with all the characteristics required for the invention, in other words it is sufficiently rigid to be formable by punching, has the required values of water permeation speed and a device of the invention made with this membrane does not loose particles of the solid material. The thickness of a woven-non-woven membrane suitable to the purposes of the invention is preferably not larger than 0.15 mm: obviously thicker membranes would meet the requirement of mechanical resistance but reducing at the same time the thickness available for the moisture sorbing material.

The moisture sorbing material may be any material having a water equilibrium pressure lower than 10⁻² mbar throughout the whole range of temperatures of employment foreseen for the OLED displays, approximately between -15°C and 130°C. Among these materials the oxides of alkaline-earth metals are preferred such as CaO, SrO and BaO; CaO is particularly preferred as it does not cause safety or environmental problems during the manufacturing steps or the disposal of OLEDs, as well as owing to its low cost. The sorbing material is preferably in powdered form with particle size generally comprised between 1 and 300 µm, and preferably comprised between 10 and 100 µm. It is possible to add to the moisture sorbing material powder of other materials, for example small quantities of inert materials such as alumina, with the function of preventing from an excessive bulk effect of the material as a consequence of the water sorption, or of materials sorbing other gases, e.g. oxygen, hydrogen or carbon oxides.
The mono- or bi-adhesive sheets (or tapes) are well known and used in a number of technological applications. These sheets or tapes are generally formed from a substrate (a thin sheet of plastic material) on one or both the faces of which there is a layer of adhesive material. For example the substrate can be made in polyethylene terephtalate (PET), with thickness comprised between 4-5 and 10-20 µm, while the adhesive layers are made with acrylic materials having a thickness in the order of tens of microns. Adhesive sheets or tapes of this type are commercially available for example from the Japanese company Nitto-Denko under the catalogue No. HJ-3160W or from the Japanese company Teraoka under catalogue No. 707: the latter sheet has a total thickness of about 30 µm and therefore it is particularly suitable to the purposes of thickness reduction of the devices according to the invention.

The invention will be described in the following with reference to the drawings in which:
- Figure 1 schematically shows the cross-section of an OLED display;
- Figure 2 shows in cross-section and schematically an OLED display comprising a moisture sorbing device of the prior art;
- Figure 3 schematically shows in cross-section a first embodiment of the moisture sorbing device of the invention;
- Figure 4 schematically shows in cross-section an alternative embodiment of the moisture sorbing device of the invention;
- Figure 5 schematically shows in cross-section an OLED display including a moisture sorbing device of the invention; and
- Figure 6 illustrates the main steps of the process for manufacturing the device of the invention.

For the sake of drawing clarity, the elements shown in the drawings are not in scale and in particular the thicknesses have been considerably increased with respect to the actual size.

Figures 1 and 2 have already been described when discussing the prior art.

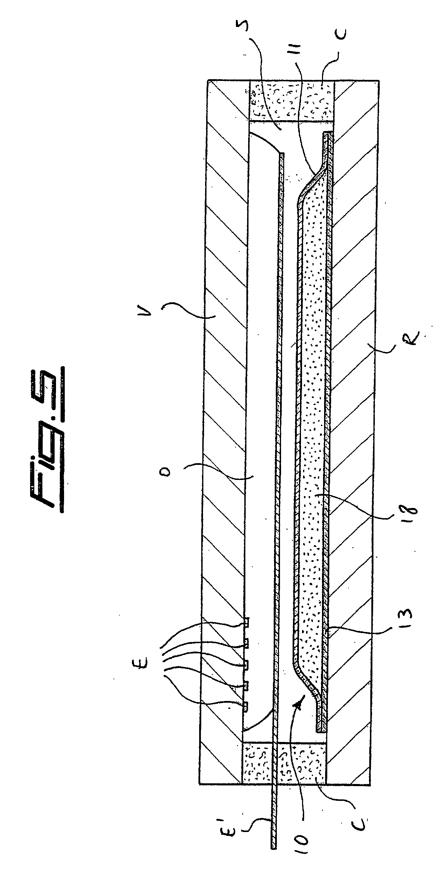

Figure 3 shows in cross-section a first possible moisture sorbing device of the invention. The device 10 is formed of a membrane 11 with a perimetral edge 12 upraised with respect to the central portion. Along the whole edge 12, to the membrane 11 there is fixed a mono-adhesive sheet 13 formed of a polymeric sheet 14 bearing a layer of adhesive material 15. The sheet 13 is coupled to the membrane along a peripheral zone 16 with the polymeric sheet 14 in contact with the membrane 11. The coupling can be obtained by gluing or heat sealing according to the type of membrane used; in particular is always possible a coupling by means of glues, while when the membrane is made of polymeric material, it can be carried out by heat sealing, generally through the use of pressure bars being heated to temperatures of about 100°C, as known in the technique. Between the central portion of the membrane and the sheet 13 an enclosure 17 is defined which is filled with the moisture sorbing material 18; the drawing shows a partial filling to emphasize the enclosure 17, but in the real devices the latter is obviously completely filled with material 18. The device 10 is supplied to the OLEDs manufactures with a non-adhesive film for protecting the adhesive material 15: this is removed immediately before positioning the device in the OLED display and is not shown in the drawing.

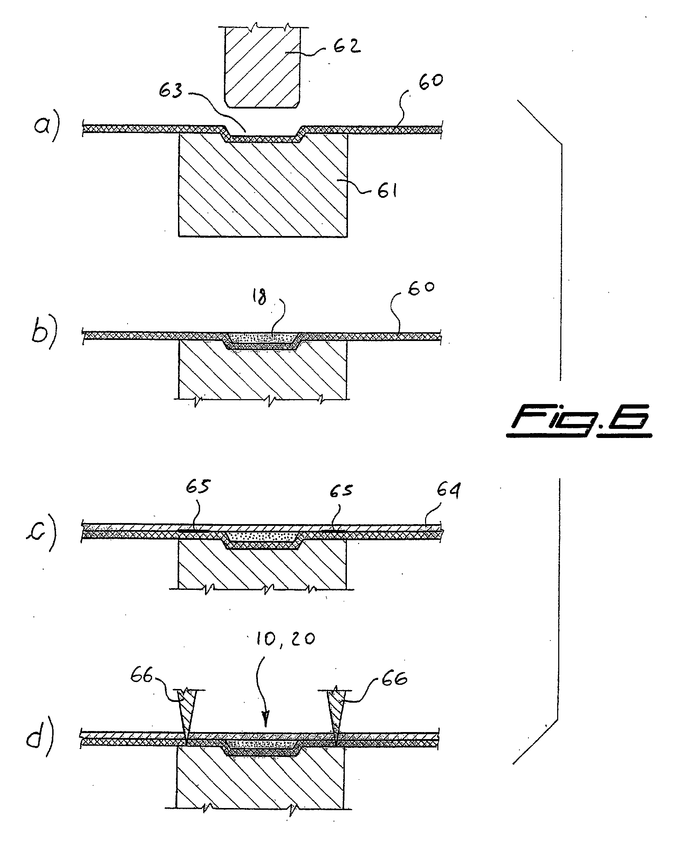

Figure 4 shows a possible alternative embodiment of the device of the invention. The device 20 is similar to that of figure 3 (similar elements in the two figures are referred to with the same numerals), but in this case instead of the mono-adhesive sheet 13 a bi-adhesive sheet 21 is used which is formed of a polymeric sheet 22 bearing on both faces layers of adhesive material 23, 23'. The membrane 11 and sheet 21 can be again fixed to each other by heat sealing, but gluing can be preferable in this case through exploitation of the layer of adhesive material 23. Also in this case the drawing does not show the non-adhesive film protecting the layer of adhesive material 23'.

In figure 5 there is schematically shown a cross-section of an OLED containing a moisture sorbing device of the invention (the case of device 10 is exemplified): the device 10 has the membrane 11 directed toward the enclosure S and the layer of adhesive material 15 (not shown in the drawing) of the sheet 13 in contact with the OLED second support, R. By comparison with figure 2 it is noted how in this case sheet 13 combines the functions of sealing the device 10 and of adhesion to the support R, thus rendering superfluous the sheet B with a resulting reduction of thickness.

In a second aspect thereof the invention deals with a process for manufacturing a moisture sorbing system, which generally comprises the steps of:
- preparing a sheet of a water-permeable membrane capable of retaining powders and having a sufficient mechanical solidity to be formable by punching;
- forming by punching at least one hollow in said membrane sheet;
- filling said hollow with powder of a moisture sorbing material;
- fixing a mono- or bi-adhesive sheet to the membrane sheet along a continuous peripheral zone surrounding the hollow.

The process is schematically represented in figure 6. In the first step, a , the membrane sheet 60 is placed between a die 61 and a punch 62, thus forming in the sheet a hollow 63. In the subsequent step, b, the hollow 63 is filled to the top level with powder 18 of the moisture sorbing material (or a possible mixture of this material with others, as stated above). The filling to the top level consists in pouring a suitable quantity of powdered material in the hollow 63 and removing a possible exceeding portion by "scraping" the surface of sheet 60 by a suitable blade. In the step c, on the sheet 60 the mono- or bi-adhesive sheet 64 is placed and the two sheets are fixed to each other by gluing or heat sealing along a continuous zone 65 around the hollow 63, upon having removed the non-adhesive film protecting layer of adhesive material 23 when a bi-adhesive sheet is used; otherwise the film of protection of layers 15 or 23' remains in the resulting device and will be removed immediately before positioning the device of the invention in an OLED.

The described process is relating to the production of a single sorption device each time but obviously, for reasons for productivity and economy, the process is preferably carried out in continuous, by using both the sheet forming the membrane and the mono- or bi-adhesive sheet in the form of tapes continuously fed in the hollow forming stations, filling with the sorbing material and sealing by the adhesive sheet; in alternative big size sheets can be used and the steps mentioned above are performed at the same time on a plurality of devices. In both cases a number of sorption devices are obtained from each pair of sheets and the single devices 10 or 20 are then manufactured through a further step d, wherein the single sorption device is obtained by shearing or mechanical cutting with the tools schematically referred to in the drawings as elements 66, also cutting the protecting film (not shown) of the adhesive layer 15 or 23'. In alternative (option not represented in the drawing) it is possible to proceed with a dinking step, by cutting with suitable tools only the sheets or tapes 60 and 64 but not the non-adhesive film protecting the layers 15 or 23'. This procedure is that adopted for example in producing the adhesive labels and in this case brings, as a result, to continuous sheets or tapes on which there are a number of devices of the invention; these can then be detached one by one from the non-adhesive film, thus resulting ready to be positioned in the OLED.

In case the sheets 60 and 64 are fixed together by means of heat sealing, the steps **c** and **d** (or the step **c** and the dinking step) may also be carried out at the same time.

## Claims

1. Moisture sorbing device (10; 20) for screens of the light emitting organic diodes type, formed of:
- a membrane (11) being permeable to water but capable of retaining solid particles, having a peripheral edge (12) upraised with respect to its central portion;
- a mono- (13) or bi-adhesive sheet (21) capable of retaining solid particles and fixed to the membrane along the whole peripheral edge thus defining with the membrane an enclosed volume (17) at said central portion of the membrane itself.
- a moisture sorbing material (18) with a water equilibrium pressure lower than 10⁻² mbar between -15°C e 130°C in said enclosed volume.

2. A device according to claim 1 in which the membrane has a water conductivity higher than 0.1 mg/(hour x cm²).

3. A device according to claim 1 in which the membrane is formed of a material chosen among wire nets, polymeric fabrics, metallic or polymeric sheets with micro-holes and uniform distribution and size of micro-holes.

4. A device according to claim 3, in which said micro-holes have a size not larger than 20 µm.

5. A device according to claim 1 in which the membrane is made from a material with non-uniform distribution and size of the pores.

6. A device according to claim 1 in which said membrane is made from an aluminum sheet with a thickness of less than 5 µm.

7. A device according to claim 1 in which the membrane is made from a high density polyethylene woven-non-woven fabric having a thickness of 0.12 mm or higher.

8. A device according to claim 7 in which the membrane has a thickness of less than 0.15 mm.

9. A device according to claim 1 in which a mono-adhesive sheet is used, formed of a polymeric sheet (14) bearing a layer of adhesive material (15), and in which the polymeric sheet (14) is in contact with the membrane (11).

10. A device according to claim 9 in which the membrane and the mono-adhesive sheet are fixed to each other by gluing or heat sealing.

11. A device according to claim 1 in which a bi-adhesive sheet (21) is used, formed of a polymeric sheet (22) bearing on both the faces layers of adhesive material (23, 23').

12. A device according to claim 11 in which the membrane and the to-fold adhesive sheet are fixed to each other by gluing or heat sealing.

13. A device according to claim 1 in which the moisture sorbing material is chosen among CaO, SrO and BaO.

14. A device according to claim 1 in which the moisture sorbing material is in powdered form.

15. A device according to claim 14 in which the moisture sorbing material has a particle size comprised between 1 and 300 µm.

16. A device according to claim 15 in which the moisture sorbing material has a particle size comprised between 10 and 100 µm.

17. A device according to claim 1 including, in addition to the moisture sorbing sorption, one or more inert materials preventing from bulking of the moisture sorbing material or of other gas sorbing materials.

18. A process for the production of a moisture sorbing system, comprising the steps of:
- preparing a sheet of a membrane (60) being water-permeable but capable of retaining powders and having a sufficient mechanical solidity to be formable by punching;
- forming by punching at least one hollow (63) in said membrane sheet between a die (61) and a punch (62);
- filling said hollow with powder of a moisture sorbing material (18);
- fixing to the membrane sheet along a continuous peripheral zone (65) around the hollow a mono- or bi-adhesive sheet (64).

19. A process according to claim 18, further comprising the step of cutting or shearing said membrane sheets (60) and mono- or bi-adhesive sheets (64).

20. Screen of the light emitting organic diodes type, consisting of a first transparent support (V) and a second support (R), joined along their whole periphery by a sealing material (C) thus defining an inner enclosure (S); a structure in contact with the first support formed of two rows of electrodes at right angles to each other (E, E') with an intermediate electroluminescent organic material (O); and a moisture sorbing device according to claim 1 in contact with said second support, whereby said peripheral edge of said device is in contact with said second support.
